# EUROPEAN PATENT APPLICATION

(11) **EP 4 428 910 A2**
(43) Date of publication of application: **11.09.2024**
(21) Application number: 23220088.1
(22) Date of filing: 22.12.2023
(51) Int. Cl.: H01L 21/8234, H01L 27/088, H01L 29/06, H01L 29/66, H01L 29/775

(54) **INTEGRATED CIRCUIT DEVICE WITH BACKSIDE FIN TRIM ISOLATION**

(30) Priority: 09.03.2023 US 202318181155
(71) Applicant: INTEL Corporation, Santa Clara, CA 95054 (US); Golonzka, Oleg, Beaverton, Oregon 97007 (US)
(72) Inventor: GOLONZKA, Oleg, Beaverton, 97007 (US); XU, Guowei, Portland, 97229 (US); HUANG, Chiao-Ti, Portland, 97229 (US); CHAO, Robin, Portland, 97209 (US); CHU, Tao, Portland, 97229 (US); ZHANG, Feng, Portland, 97229 (US); ZHANG, Yang, Rio Rancho, 87124 (US); GUHA, Biswajeet, Hillsboro, 97124 (US)
(74) Representative: 2SPL Patentanwälte PartG mbB

(57) **Abstract**

An IC device includes a backside fin trim isolation (FTI, 150) separating a first transistor (170A) from a second transistor (170B). The FTI may be between a source region of the first transistor and a drain region of the second transistor. The source region of the first transistor and the drain region of the second transistor may be different portions of a semiconductor structure, e.g., a fin or nanoribbon. The IC device may also include a frontside metal layer (125). The semiconductor structure has a first surface and a second surface opposing the first surface. The first surface of the semiconductor structure is closer to the metal layer and may be larger than the second surface of the semiconductor structure. The FTI may has a first surface and a second surface opposing the first surface. The first surface of the FTI is closer to the metal layer but may be smaller than the second surface of the FTI.

## Description

### Background

Integrated circuit (IC) fabrication usually includes two stages. The first stage is referred to as the front end of line (FEOL). The second stage is referred to as the back end of line (BEOL). In the FEOL, individual semiconductor devices components (e.g., transistor, capacitors, resistors, etc.) can be patterned on a wafer. A dielectric structure may be used to separate semiconductor structures of adjacent semiconductor devices. Such a dielectric structure may be referred to as fin trim isolation (FTI) or diffusion break. In the BEOL, metal layers, vias, and insulating layers can be formed to get the individual components interconnected. The BEOL usually starts with forming the first metal layer on the wafer. The first metal layer is often called M0. More metal layers can be formed on top of M0, and these metal layers are often called M1, M2, and so on.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 illustrates an IC device comprising an FEOL section and a BEOL section, according to some embodiments of the disclosure.
FIG. 2 illustrates an IC device comprising a frontside FTI, according to some embodiments of the disclosure.
FIG. 3 illustrates an IC device comprising a backside FTI, according to some embodiments of the disclosure.
FIG. 4A is a top view of an IC device with frontside FTI, according to some embodiments of the disclosure.
FIG. 4B is a top view of an IC device with backside FTI, according to some embodiments of the disclosure.
FIGS. 5A-5N illustrate a process of forming backside FTI, according to some embodiments of the disclosure.
FIGS. 6A-6B are top views of a wafer and dies that may include backside FTI, according to some embodiments of the disclosure.
FIG. 7 is a side, cross-sectional view of an example IC package that may include one or more IC devices having backside FTI, according to some embodiments of the disclosure.
FIG. 8 is a cross-sectional side view of an IC device assembly that may include components having one or more IC devices implementing backside FTI, according to some embodiments of the disclosure.
FIG. 9 is a block diagram of an example computing device that may include one or more components with backside FTI, according to some embodiments of the disclosure.

### Detailed Description

The systems, methods, and devices of this disclosure each have several innovative aspects, no single one of which is solely responsible for all the desirable attributes disclosed herein. Details of one or more implementations of the subject matter described in this specification are set forth in the description below and the accompanying drawings.

Continued scaling of transistors creates challenges for forming FTI structures between adjacent transistors. With currently available FTI processes, FTI structures typically have a shape with a larger top and gradually narrowing bottom. However, semiconductor structures of transistors (e.g., fins, nanoribbons, etc.) usually have a shape with a smaller top and a larger bottom. The difference in the shape of FTI structures and the shape of semiconductor structures can cause FTI fangs, which can lead to elevated current leakage. To reduce such fangs, the FTI open area needs to be enlarged, which, however, can cause damage in the epitaxial structures and shortage between source contact and drain contact, resulting in degradation in the performance of the transistors. Therefore, improved technology for FTI process is needed.

Embodiments of the present disclosure may improve on at least some of the challenges and issues described above by providing backside FTI structures. Backside FTI structures can be formed by forming an opening from the backside of IC devices. That can cause the FTI structures to have a smaller top and a larger bottom. Such as shape can match (e.g., be the same or similar as) the shape of the semiconductor structures.

In various embodiments of the present disclosure, an IC device includes a plurality of transistor. A backside FTI structure may be formed between two adjacent transistors. For example, the backside FTI structure may be between a source region of a first transistor and a drain region of a second transistor. The source region of the first transistor and the drain region of the second transistor may be different portions of a semiconductor structure, e.g., a fin or nanoribbon. The semiconductor structure may have a top surface and a bottom surface opposing the top surface. The top surface of the semiconductor structure may be closer to one or more metal layers in the IC device, e.g., in a BEOL section of the IC device. The top surface of the semiconductor structure may have a larger size than the bottom surface of the semiconductor structure. Similarly, the backside FTI structure may have a top surface and a bottom surface opposing the top surface. The top surface of the backside FTI structure may be closer to the one or more metal layers and have a larger size than the bottom surface.

The IC device may include more than one backside FTI structure, e.g., in embodiments where the IC device includes three or more transistors. A backside FTI structure may be placed between each pair of transistors. A transistor may be between two adjacent backside FTI structures. Backside FTI can overcome the drawbacks of frontside FTI, including EP damage, FTI fang, trench contact shortage, and so on. Therefore, IC devices with backside FTI can have better performance than currently available IC devices.

It should be noted that, in some settings, the term "nanoribbon" has been used to describe an elongated semiconductor structure that has a substantially rectangular transverse cross-section (e.g., a cross-section in a plane perpendicular to the longitudinal axis of the structure), while the term "nanowire" has been used to describe a similar structure but with a substantially circular or square transverse cross-sections. In the following, a single term "nanoribbon" is used to describe an elongated semiconductor structure independent of the shape of the transverse cross-section. Thus, as used herein, the term "nanoribbon" is used to cover elongated semiconductor structures that have substantially rectangular transverse cross-sections (possibly with rounded corners), elongated semiconductor structures that have substantially square transverse cross-sections (possibly with rounded corners), elongated semiconductor structures that have substantially circular or elliptical/oval transverse cross-sections, as well as elongated semiconductor structures that have any polygonal transverse cross-sections.

In the following, some descriptions may refer to a particular source or drain (S/D) region or contact being either a source region/contact or a drain region/contact. However, unless specified otherwise, which region/contact of a transistor or diode is considered to be a source region/contact and which region/contact is considered to be a drain region/contact is not important because, as is common in the field of FETs, designations of source and drain are often interchangeable. Therefore, descriptions of some illustrative embodiments of the source and drain regions/contacts provided herein are applicable to embodiments where the designation of source and drain regions/contacts may be reversed.

As used herein, the term "metal layer" may refer to a layer above a substrate that includes electrically conductive interconnect structures for providing electrical connectivity between different IC components. Metal layers described herein may also be referred to as "interconnect layers" to clearly indicate that these layers include electrically conductive interconnect structures which may, but do not have to be, metal.

The systems, methods and devices of this disclosure each have several innovative aspects, no single one of which is solely responsible for all of the desirable attributes disclosed herein. Details of one or more implementations of the subject matter described in this specification are set forth in the description below and the accompanying drawings.

In the following detailed description, various aspects of the illustrative implementations may be described using terms commonly employed by those skilled in the art to convey the substance of their work to others skilled in the art. For example, the term "connected" means a direct electrical or magnetic connection between the things that are connected, without any intermediary devices, while the term "coupled" means either a direct electrical or magnetic connection between the things that are connected, or an indirect connection through one or more passive or active intermediary devices. The term "circuit" means one or more passive and/or active components that are arranged to cooperate with one another to provide a desired function. If used, the terms "oxide," "carbide," "nitride," etc. refer to compounds containing, respectively, oxygen, carbon, nitrogen, etc., the term "high-k dielectric" refers to a material having a higher dielectric constant (k) than silicon oxide, while the term "low-k dielectric" refers to a material having a lower k than silicon oxide. The terms "substantially," "close," "approximately," "near," and "about," generally refer to being within +/-10%, e.g., within +/- 5% or within +/- 2%, of a target value based on the context of a particular value as described herein or as known in the art. Similarly, terms indicating orientation of various elements, e.g., "coplanar," "perpendicular," "orthogonal," "parallel," or any other angle between the elements, generally refer to being within +/- 8% of a target value, e.g., within +/- 5% of a target value or within +/- 2% of a target value, based on the context of a particular value as described herein or as known in the art. Also, the term "or" refers to an inclusive "or" and not to an exclusive "or."

The terms "over," "under," "between," and "on" as used herein refer to a relative position of one material layer or component with respect to other layers or components. For example, one layer disposed over or under another layer may be directly in contact with the other layer or may have one or more intervening layers. Moreover, one layer disposed between two layers may be directly in contact with the two layers or may have one or more intervening layers. In contrast, a first layer "on" a second layer is in direct contact with that second layer. Similarly, unless explicitly stated otherwise, one feature disposed between two features may be in direct contact with the adjacent features or may have one or more intervening layers.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges. As used herein, the notation "A/B/C" means (A), (B), and/or (C).

The description may use the phrases "in an embodiment" or "in embodiments," which may each refer to one or more of the same or different embodiments. Furthermore, the terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. Unless otherwise specified, the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

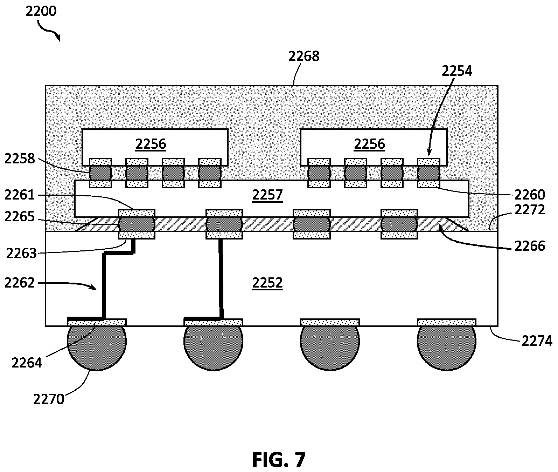

In the following detailed description, reference is made to the accompanying drawings that form a part hereof, and in which is shown, by way of illustration, embodiments that may be practiced. It is to be understood that other embodiments may be utilized and structural or logical changes may be made without departing from the scope of the present disclosure. Therefore, the following detailed description is not to be taken in a limiting sense. For convenience, if a collection of drawings designated with different letters are present, e.g., FIGS. 7A-7B, such a collection may be referred to herein without the letters, e.g., as "FIG. 7."

In the drawings, some schematic illustrations of example structures of various devices and assemblies described herein may be shown with precise right angles and straight lines, but it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication. Inspection of layout and mask data and reverse engineering of parts of a device to reconstruct the circuit using e.g., optical microscopy, TEM, or SEM, and/or inspection of a cross-section of a device to detect the shape and the location of various device elements described herein using, e.g., Physical Failure Analysis (PFA) would allow determination of presence of backside FTIs as described herein.

Various operations may be described as multiple discrete actions or operations in turn in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

Various IC devices with backside FTI as described herein may be implemented in, or associated with, one or more components associated with an IC or/and may be implemented between various such components. In various embodiments, components associated with an IC include, for example, transistors, diodes, power sources, resistors, capacitors, inductors, sensors, transceivers, receivers, antennas, etc. Components associated with an IC may include those that are mounted on IC or those connected to an IC. The IC may be either analog or digital and may be used in a number of applications, such as microprocessors, optoelectronics, logic blocks, audio amplifiers, etc., depending on the components associated with the IC. The IC may be employed as part of a chipset for executing one or more related functions in a computer.

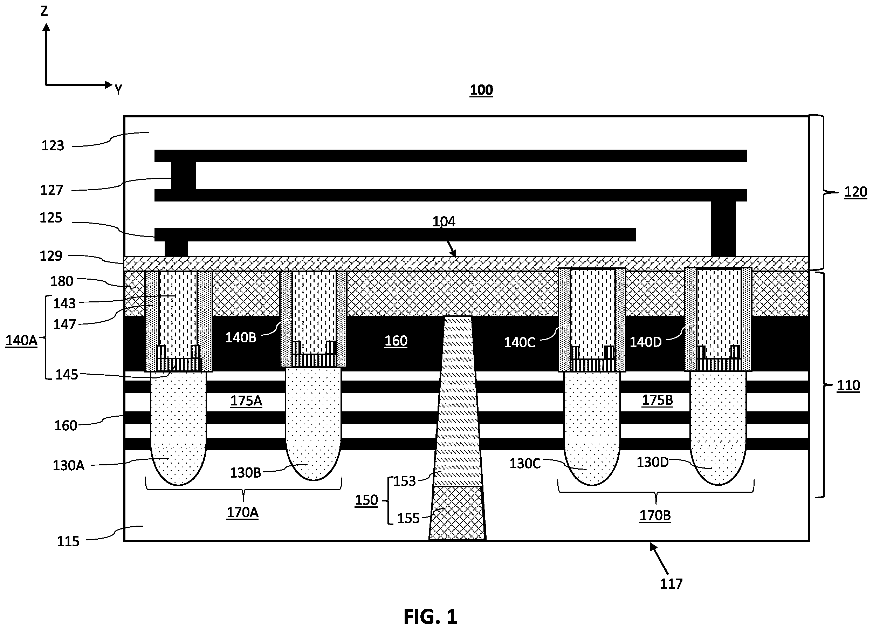

FIG. 1 illustrates an IC device 100 comprising an FEOL section 110 and a BEOL section 120, according to some embodiments of the disclosure. For the purpose of illustration, FIG. 1 shows a cross-sectional view of the IC device 100 in the Y-Z plane. The FEOL section 110 includes a support structure 115, a FTI structure 150, conductive structures 160 (individually referred to as "conductive structure 160"), transistors 170A and 170B (collectively referred to as "transistors 170" or "transistor 170"), and a dielectric layer 180. The BEOL section 120 includes an insulative structure 123, metal layers 125 (individually referred to as "metal layer 115"), vias 127 (individually referred to as "via 117"), and a contact layer 129. In other embodiments, the IC device 100 may include fewer, more, or different components. For instance, the FEOL section 110 may include more transistors or other types of semiconductor devices, such as resistor, capacitor, inductor, etc. Also, the BEOL section 120 may include a different number of metal layers 125 or a different number of vias 127.

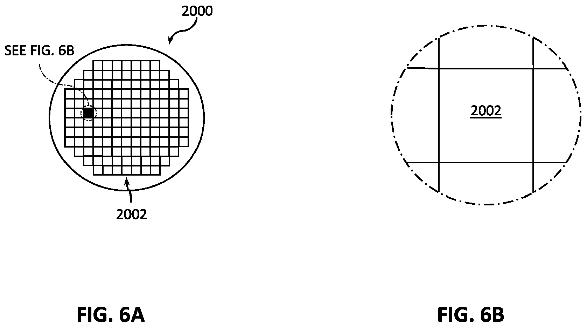

The support structure 115 may be any suitable structure, such as a substrate, a die, a wafer, or a chip, based on which transistors can be built. The support structure 115 may, e.g., be the wafer 2000 of FIG. 6A, discussed below, and may be, or be included in, a die, e.g., the singulated die 2002 of FIG. 6B, discussed below. In some embodiments, the support structure 115 may be a semiconductor substrate composed of semiconductor material systems including, for example, n-type or p-type materials systems, and, in some embodiments, the channel region, described herein, may be a part of the support structure 115. In some embodiments, the semiconductor substrate may be a crystalline substrate formed using a bulk silicon or a silicon-on-insulator substructure. In other embodiments, the semiconductor substrate may be formed using alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of group III-V, group II-VI, or group IV materials. In some embodiments, the substrate may be non-crystalline. In some embodiments, the support structure may be a printed circuit board (PCB) substrate. One or more transistors, such as the transistors 170, may be built on the support structure 115.

Although a few examples of materials from which the support structure 115 may be formed are described here, any material that may serve as a foundation upon which an IC may be built falls within the spirit and scope of the present disclosure. In various embodiments, the support structure 115 may include any such substrate, possibly with some layers and/or devices already formed thereon, not specifically shown in the present figures. As used herein, the term "support" does not necessarily mean that it provides mechanical support for the IC devices/structures (e.g., transistors, capacitors, interconnects, and so on) built thereon. For example, some other structure (e.g., a carrier substrate or a package substrate) may provide such mechanical support and the support structure 115 may provide material "support" in that, e.g., the IC devices/structures described herein are build based on the semiconductor materials of the support structure 115. However, in some embodiments, the support structure 115 may provide mechanical support.

A transistor 170 may be a field-effect transistor (FET), such as metal-oxide-semiconductor FET (MOSFET), tunnel FET (TFET), fin-based transistor (e.g., FinFET), nanoribbon-based transistor, gate-all-around (GAA) transistor, other types of FET, or some combination thereof. A transistor 170 includes a semiconductor structure that includes a channel region, a source region, and a drain region. The semiconductor structure of the transistor 170 may be at least partially in the support structure 115. The support structure 115 may include a semiconductor material, from which at least a portion of the semiconductor structure is formed. The semiconductor structure of the transistor 170 (or a portion of the semiconductor structure, e.g., the channel region) may be a planar structure or a non-planar structure. A non-planar structure is a three-dimensional structure, such as fin, nanoribbon (e.g., nanosheet, nanowire, etc.), and so on. A non-planar structure may have a longitudinal axis and a transvers cross-section perpendicular to the longitudinal axis. In some embodiments, a dimension of the non-planar structure along the longitudinal axis may be greater than dimensions along other directions, e.g., directions along axes perpendicular to the longitudinal axis.

In the embodiments of FIG. 1, the source and drain regions of the transistors 170 are semiconductor regions 130A and 130B (collectively referred to as "semiconductor regions 130" or "semiconductor region 130"). In an example, the semiconductor region 130A is the source region of the transistor 170A, the semiconductor region 130B is the drain region of the transistor 170A, semiconductor region 130C is the source region of the transistor 170B, and the semiconductor region 130D is the drain region of the transistor 170B. The channel region of the transistor 170A include semiconductor regions 175A (individually referred to as "semiconductor region 175A"), which are between the conductive structure 160 and between the semiconductor region 130A and the semiconductor region 130B. The channel region of the transistor 170B include semiconductor regions 175B (individually referred to as "semiconductor region 175B"), which are between the conductive structure 160 and between the semiconductor region 130C and the semiconductor region 130D. In the embodiments of FIG. 1, the channel region in each transistor 170 includes four ribbons, which may be under the corresponding portions of the four conductive structures 160. In other embodiments, the channel region may include a different number of ribbon(s) or have a different shape.

A channel region may include a channel material. The channel material may be composed of semiconductor material systems including, for example, n-type or p-type materials systems. In some embodiments, the channel material may include a high mobility oxide semiconductor material, such as tin oxide, antimony oxide, indium oxide, indium tin oxide, titanium oxide, zinc oxide, indium zinc oxide, gallium oxide, titanium oxynitride, ruthenium oxide, or tungsten oxide. In some embodiments, the channel material may include a compound semiconductor with a first sub-lattice of at least one element from Group III of the periodic table (e.g., Al, Ga, In), and a second sub-lattice of at least one element of group V of the periodic table (e.g., P, As, Sb). In some embodiments, the channel material may include a compound semiconductor with a first sub-lattice of at least one element from Group II of the periodic table (e.g., Zn, Cd, Hg), and a second sub-lattice of at least one element of Group IV of the periodic table (e.g., C, Si, Ge, Sn, Pb). In some embodiments, the channel material is an epitaxial semiconductor material deposited using an epitaxial deposition process. The epitaxial semiconductor material may have a polycrystalline structure with a grain size between about 2 nm and 100 nm, including all values and ranges therein.

For some example n-type transistor embodiments (i.e., for the embodiments where the transistor 170 is an NMOS (n-type metal-oxide-semiconductor) transistor or an n-type TFET), the channel material may advantageously include a III-V material having a high electron mobility, such as, but not limited to InGaAs, InP, InSb, and InAs. For some such embodiments, the channel material may be a ternary III-V alloy, such as InGaAs, GaAsSb, InAsP, or InPSb. For some InxGa1-xAs fin embodiments, In content (x) may be between 0.6 and 0.9, and may advantageously be at least 0.7 (e.g., In0.7Ga0.3As). In some embodiments with highest mobility, the channel material may be an intrinsic III-V material, i.e., a III-V semiconductor material not intentionally doped with any electrically active impurity. In alternate embodiments, a nominal impurity dopant level may be present within the channel material, for example to further fine-tune a threshold voltage Vt, or to provide HALO pocket implants, etc. Even for impurity-doped embodiments however, impurity dopant level within the channel material may be relatively low, for example below 10¹⁵ dopant atoms per cubic centimeter (cm⁻³), and advantageously below 10¹³ cm⁻³. These materials may be amorphous or polycrystalline, e.g., having a crystal grain size between 0.5 nanometers and 100 nanometers.

For some example p-type transistor embodiments (i.e., for the embodiments where the transistor 170 is a PMOS (p-type metal-oxide-semiconductor) transistor or a p-type TFET), the channel material may advantageously be a Group IV material having a high hole mobility, such as, but not limited to Ge or a Ge-rich SiGe alloy. For some example embodiments, the channel material may have a Ge content between 0.6 and 0.9, and advantageously may be at least 0.7. In some embodiments with highest mobility, the channel material may be intrinsic III-V (or IV for p-type devices) material and not intentionally doped with any electrically active impurity. In alternate embodiments, one or more a nominal impurity dopant level may be present within the channel material, for example to further set a threshold voltage (Vt), or to provide HALO pocket implants, etc. Even for impurity-doped embodiments however, impurity dopant level within the channel portion is relatively low, for example below 10¹⁵ cm⁻³, and advantageously below 10¹³ cm⁻³. These materials may be amorphous or polycrystalline, e.g., having a crystal grain size between 0.5 nanometers and 100 nanometers.

In some embodiments, the channel material may include a high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, aluminum zinc oxide, or tungsten oxide. In general, for a thin-film transistor (TFT), the channel material may include one or more of tin oxide, cobalt oxide, copper oxide, antimony oxide, ruthenium oxide, tungsten oxide, zinc oxide, gallium oxide, titanium oxide, indium oxide, titanium oxynitride, indium tin oxide, indium zinc oxide, nickel oxide, niobium oxide, copper peroxide, IGZO, indium telluride, molybdenite, molybdenum diselenide, tungsten diselenide, tungsten disulfide, molybdenum disulfide, n- or p-type amorphous or polycrystalline silicon, monocrystalline silicon, germanium, indium arsenide, indium gallium arsenide, indium selenide, indium antimonide, zinc antimonide, antimony selenide, silicon germanium, gallium nitride, aluminum gallium nitride, indium phosphite, black phosphorus, zinc sulfide, indium sulfide, gallium sulfide, each of which may possibly be doped with one or more of gallium, indium, aluminum, fluorine, boron, phosphorus, arsenic, nitrogen, tantalum, tungsten, and magnesium, etc. In some embodiments, a thin-film channel material may be deposited at relatively low temperatures, which allows depositing the channel material within the thermal budgets imposed on back-end fabrication to avoid damaging other components, e.g., front end components such as logic devices.

As noted above, the channel material may include IGZO. IGZO-based devices have several desirable electrical and manufacturing properties. IGZO has high electron mobility compared to other semiconductors, e.g., in the range of 20-50 times than amorphous silicon. Furthermore, amorphous IGZO (a-IGZO) transistors are typically characterized by high band gaps, low-temperature process compatibility, and low fabrication cost relative to other semiconductors.

IGZO can be deposited as a uniform amorphous phase while retaining higher carrier mobility than oxide semiconductors such as zinc oxide. Different formulations of IGZO include different ratios of indium oxide, gallium oxide, and zinc oxide. One particular form of IGZO has the chemical formula InGaO₃(ZnO)₅. Another example form of IGZO has an indium:gallium:zinc ratio of 1:2:1. In various other examples, IGZO may have a gallium to indium ratio of 1:1, a gallium to indium ratio greater than 1 (e.g., 2:1, 3:1, 4:1, 5:1, 6:1, 7:1, 8:1, 9:1, or 10:1), and/or a gallium to indium ratio less than 1 (e.g., 1:2, 1:3, 1:4, 1:5, 1:6, 1:7, 1:8, 1:9, or 1:10). IGZO can also contain tertiary dopants such as aluminum or nitrogen.

The source region and drain region in a transistor 170 are connected to the channel region. The source region and drain region may each include a semiconductor material with dopants. In some embodiments, the source region and drain region have the same semiconductor material, which may be the same as the channel material of the channel region. A semiconductor material of the source region or the drain region may be a Group IV material, a compound of Group IV materials, a Group III/V material, a compound of Group III/V materials, a Group II/VI material, a compound of Group II/VI materials, or other semiconductor materials. Example Group II materials include zinc (Zn), cadmium (Cd), and so on. Example Group III materials include aluminum (Al), boron (B), indium (In), gallium (Ga), and so on. Example Group IV materials include silicon (Si), germanium (Ge), carbon (C), etc. Example Group V materials include nitrogen (N), phosphorus (P), arsenic (As), antimony (Sb), and so on. Example Group VI materials include sulfur (S), selenium (Se), tellurium (Te), oxygen (O), and so on. A compound of Group IV materials can be a binary compound, such as SiC, SiGe, and so on. A compound of Group III/V materials can be a binary, tertiary, or quaternary compound, such as GaN, InN, and so on. A compound of Group II/VI materials can be a binary, tertiary, or quaternary compounds, such as CdSe, CdS, CdTe, ZnO, ZnSe, ZnS, ZnTe, CdZnTe, CZT, HgCdTe, HgZnTe, and so on.

In some embodiments, the dopants in the source region and the drain region are the same type. In other embodiments, the dopants of the source region and the drain region may be different (e.g., opposite) types. In an example, the source region has n-type dopants and the drain region has p-type dopants. In another example, the source region has p-type dopants and the drain region has n-type dopants. Example n-type dopants include Te, S, As, tin (Sn), Si, Ga, Se, S, In, Al, Cd, chlorine (CI), iodine (I), fluorine (F), and so on. Example p-type dopants include beryllium (Be), Zn, magnesium (Mg), Sn, P, Te, lithium (Li), sodium (Na), Ga, Cd, and so on.

In some embodiments, the source region and the drain region may be highly doped, e.g., with dopant concentrations of about 1·10²¹ cm⁻³, in order to advantageously form Ohmic contacts with the respective S/D contacts (also sometimes interchangeably referred to as "S/D electrodes"), although these regions may also have lower dopant concentrations and may form Schottky contacts in some implementations. Irrespective of the exact doping levels, the source region and the drain region may be the regions having dopant concentration higher than in other regions, e.g., higher than a dopant concentration in the channel region, and, therefore, may be referred to as "highly doped" (HD) regions.

The channel region may include one or more semiconductor materials with doping concentrations significantly smaller than those of the source region and the drain region. For example, in some embodiments, the channel material of the channel region may be an intrinsic (e.g., undoped) semiconductor material or alloy, not intentionally doped with any electrically active impurity. In alternate embodiments, nominal impurity dopant levels may be present within the channel material, for example to set a threshold voltage Vt, or to provide HALO pocket implants, etc. In such impurity-doped embodiments however, impurity dopant level within the channel material is still significantly lower than the dopant level in the source region and the drain region, for example below 10¹⁵ cm⁻³ or below 10¹³ cm⁻³. Depending on the context, the term "S/D terminal" may refer to a S/D region or a S/D contact or electrode of a transistor.

The transistor 170 also includes a source contact over the source region and a drain contact over the drain region. The source contact and drain contact are also referred to as trench contacts. FIG. 1 shows four trench contacts 140A-140D (collectively referred to as "trench contacts 140" or "trench contact 140"), which are coupled to a semiconductor region 130A-130D, respectively. A trench contact 140 may include one or more electrically conductive materials to couple the semiconductor region 130 to a power plane or ground plane, which may be one or more metal layers 125 in the BEOL section 120. An electrically conductive material may be metal. Examples of metals in the trench contacts 140 may include, but are not limited to, Ru, Cu, Co, palladium (Pd), platinum (Pt), nickel (Ni), and so on. In the embodiments of FIG. 1, a trench contact 140 includes a conductive structure 143, a contact structure 145, and a spacer 147. The conductive structure 143 and the contact structure 145 are electrically conductive. The conductive structure 143 and the contact structure 145 are surrounded by the spacer 147. The spacer 147 may be electrically insulative. For instance, the spacer 147 can insulate the conductive structure 143 and the contact structure 145 from the conductive structures 160. The spacer 147 may include an electrical insulator, such as a dielectric material, hysteretic material, and so on. Example dielectric material includes oxide (e.g., Si based oxides, metal oxides, etc.), high-k dielectric, and so on. Example hysteretic material include ferroelectric materials, antiferroelectric materials, etc.

Each transistor 170 also includes a gate that is over or wraps around at least a portion of the channel region. The gate may include a portion of each conductive structure 160 (e.g., the portion between the semiconductor regions 130 of the transistor 170), which constitutes a gate electrode. In the embodiments of FIG. 1, the gate of each transistor 170 includes four gate electrodes, each of which is a portion of a different conductive structure 160. In some embodiments, the four gate electrodes may be at the same electrical potential during the operation of the transistor 170. In other embodiments, some or all of the four gate electrodes may be at different electrical potentials. The channel region of the transistor 170 may include four semiconductor regions under the four gate electrodes, respectively. The gate electrodes may be electrically coupled to a power plane, e.g., one or more meta layers 125 in the BEOL section 120. The other portions of each conductive structure 160 (e.g., a portion between the semiconductor region 130B and the FTI structure 150, a portion between the semiconductor region 130C and the FTI structure 150, etc.) may be inactive and may be referred to as dummy conductive structures. The inactive portions of the conductive structures 160 may be insulated from the power plane.

A gate electrode can be coupled to a gate terminal that controls gate voltages applied on the transistor 170. The gate electrode may include one or more gate electrode materials, where the choice of the gate electrode materials may depend on whether the transistor 170 is a p-type transistor or an n-type transistor. For a p-type transistor, gate electrode materials that may be used in different portions of the gate electrode may include, but are not limited to, Ru, Pd, Pt, Co, Ni, and conductive metal oxides (e.g., ruthenium oxide). For an n-type transistor, gate electrode materials that may be used in different portions of the gate electrode, but are not limited to, hafnium, zirconium, titanium, tantalum, aluminum, alloys of these metals, and carbides of these metals (e.g., hafnium carbide, zirconium carbide, titanium carbide, tantalum carbide, and aluminum carbide). In some embodiments, the gate may include a stack of a plurality of gate electrode materials, where zero or more materials of the stack are workfunction (WF) materials and at least one material of the stack is a fill metal layer. Further materials/layers may be included next to the gate electrode for other purposes, such as to act as a diffusion barrier layer or/and an adhesion layer.

Even though not shown in FIG. 1, a gate may also include a gate insulator that separates at least a portion of the channel region from each gate electrode so that the channel region is insulated from the gate electrode. In some embodiments, the gate insulator may wrap around at least a portion of the channel region. The gate insulator may also wrap around at least a portion of the source region or the drain region. At least a portion of the gate insulator may be wrapped around by the gate electrode. The gate insulator includes an electrical insulator, such as a dielectric material, hysteretic material, and so on. Example dielectric material includes oxide (e.g., Si based oxides, metal oxides, etc.), high-k dielectric, and so on. Example hysteretic material include ferroelectric materials, antiferroelectric materials, etc.

The FTI structure 150 separates the transistor 170A from the transistor 170B. As shown in FIG. 1, the FTI structure 150 is between the transistor 170A and the transistor 170B. The FTI structure may be fabricated by forming an opening from the backside 117 of the support structure 115. The backside 117 is the side that is further from the BEOL section 120. The FTI structure 150 includes dielectric materials that can prevent current leakage (e.g., diffusion of charges) between the two transistors 170, e.g., between the semiconductor region 130B and the semiconductor region 130C. As shown in FIG. 1, the FTI structure 150 includes dielectric structures 153 and 155. The dielectric structure 153 is over the dielectric structure 155. As the opening is formed from the backside 117, the bottom surface of the FTI structure 150 (e.g., the surface at the backside 117) is wider than the top surface (e.g., the surface contacting the dielectric layer 180). The FTI structure dielectric structure 153 is over the dielectric structure 155150 may gradually narrow along the Z axis from the bottom to the top. In some embodiments, the dielectric structure 153 includes a different material from the dielectric structure 155. The dielectric structure 155 may include an oxide, such as silicon oxide, etc. The dielectric structure 155 may include a nitride or carbide, such as silicon nitride, silicon carbide, etc. The dielectric structure 155 may have a greater hardness or higher etch selectivity than the dielectric structure 153.

In some embodiments, the dielectric structure 155 may have the same material as the dielectric layer 180. The dielectric layer 180 is between the conductive structures 160 and the contact layer 129 in the BEOL section 120. The dielectric layer 180 may insulate the trench contacts 140 from each other. The dielectric layer 180 may contact the bottom surface of the contact layer 129.

The contact layer 129 may be electrically conductive. In the embodiments of FIG. 1, different portions of the contact layer 129 contacts the top surfaces of the trench contacts 140, respectively. Electrical signals can be provided to the trench contacts 140 and further to the semiconductor regions 130 through the contact layer 129. The contact layer 129 is electrically coupled to the metal layers 125 through the vias 127. The metal layers 125 may facilitate supply of electrical signals to the transistor 170. Even though not shown in FIG. 1, the metal layers 125 may be coupled with other devices than the transistor 170, such as diodes, power sources, resistors, capacitors, inductors, sensors, transceivers, receivers, antennas. A via 127 may include a metal, such as tungsten (W), molybdenum (Mo), ruthenium (Ru), or other metals. Different vias 127 may include different materials. The vias 127 can provide a conductive channel between the metal layers 125. The metal layers 125, vias 127, or contact layer 129 may be partially or wholly surrounded by the insulative structure 123. Certain portions of the metal layers 125, vias 127, or contact layer 129 may be insulated by the insulative structure 123. The insulative structure 123 may include one or more electrical insulators. An electrical insulator may be a dielectric material, hysteretic material, and so on. Example dielectric material includes oxide (e.g., Si based oxides, metal oxides, etc.), low-k dielectric, high-k dielectric, and so on. Example hysteretic material include ferroelectric materials, antiferroelectric materials, etc.

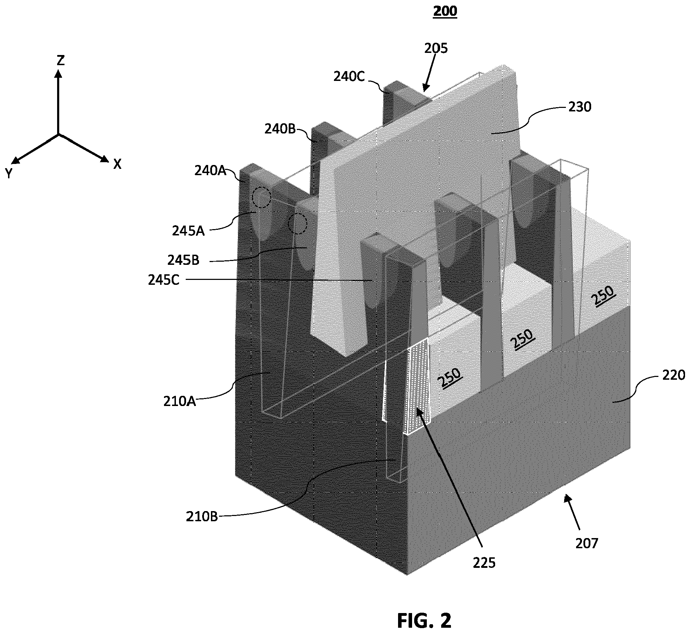

FIG. 2 illustrates an IC device 200 comprising frontside FTI, according to some embodiments of the disclosure. FIG. 2 shows a perspective view of the IC device 200. The IC device 200 has a frontside 205 and a backside 207. The IC device 200 includes two FTI structures 210A and 210B (collectively referred to as "FTI structures 210" or "FTI structure 210"), a support structure 220, a conductive structure 230, semiconductor structures 240A-240C (collectively referred to as "semiconductor structures 240" or "semiconductor structure 240"), and insulative structures 250 (individually referred to as "insulative structure 250"). In other embodiments, the IC device 200 may include fewer, more, or different components.

The support structure 220 is below the semiconductor structures 240 and the insulative structures 250. In some embodiments, the support structure 260 may include a semiconductor material. Additionally or alternatively, the support structure 260 may include an insulator, such as an oxide. The support structure 260 may be an embodiment of the support structure 115 in FIG. 1.

The FTI structures 210 are frontside FTI structures as they are formed from the frontside 205 of the IC device 200. The frontside 205 opposes the backside 207 along the Z axis. The top surfaces of the semiconductor structures 240 are at the frontside 205, versus the bottom surface of the support structure is at the backside 207. The FTI structures 210 may be formed by forming openings from the frontside 205. As a result, the top surface of a FTI structure 210 is larger than the bottom surface of the FTI structure 210, i.e., the FTI structure 210 gradually narrows in the direction from the frontside 205 to the backside 207. The FTI structures 210 include one or more dielectric materials. The FTI structures 210 can separate adjacent transistors formed over the support structure 220. The transistors include semiconductive regions that are various portions of the semiconductor structures 240.

A longitudinal axis of each FTI structure 210 is along the Y axis, which is in parallel with a longitudinal axis of the conductive structure 230. The conductive structure 230 includes one or more electrically conductive materials, such as metal. Even though FIG. 2 shows one conductive structure 230, the IC device 200 may include one or more other conductive structures. The insulative structures 250 are between the conductive structures 230 and the support structure 220. Each insulative structures 250 is between a portion of conductive structures 230 and the support structure 220 for insulating the conductive structures 230 from the support structure 220.

The semiconductor structures 240 have longitudinal axes along the X axis, which is perpendicular to the longitudinal axes of the FTI structures 210 and the conductive structure 230. In the embodiments of FIG. 2, the semiconductor structures 240 are fins. In other embodiments, the semiconductor structures 240 may have other structures, such as nanoribbon. As shown in FIG. 2, each semiconductor structure 240 crosses the conductive structure 230. Each semiconductor structure 240 may include a plurality of source regions, drain regions, and channel regions. For the purpose of illustration, each semiconductor structure 240 includes three semiconductor regions 245A-245C (collectively referred to as "semiconductor regions 245" or "semiconductor region 245") in FIG. 2.

Each semiconductor region 245 may be a source region or a drain region of a transistor. For instance, the semiconductor regions 245B and 245C may be the source region and drain region of a transistor. The channel region of the transistor may be the portion of the semiconductor structure 240 that is wrapped by the conductive structure 230 and is between the semiconductor regions 245B and 245C. The semiconductor region 245A is the source or drain region of another transistor that may function separately from the transistor including the semiconductor regions 245B and 245C. The FTI structure 210A is between the two transistors and can prevent current leakage between the two transistors. Similarly, the FTI structure 210B can prevent current leakage between the transistor including the semiconductor regions 245B and 245C and another transistor, which is not shown in FIG. 2.

The top surface of each semiconductor structure 240 is smaller than the bottom surface of the semiconductor structure 240, i.e., the semiconductor structures 240 gradually narrow in the direction from the backside 207 to the frontside 205. As described above, the FTI structures 210 gradually narrow in the direction from the frontside 205 to the backside 207. The difference in the shapes of the semiconductor structures 240 and FTI structures 210 results in FTI fangs. FIG. 2 shows a FTI fang 225. The IC device 200 may include one or more other FTI fangs. The FTI fang 225 can cause current leakage. Also, the difference in the shapes of the semiconductor structures 240 and FTI structures 210 can cause EPI (epitaxy) damage, e.g., damages to the semiconductor regions 245. For the purpose of illustration, FIG. 2 shows two areas (represented by dotted circles in FIG. 2) where EPI damage can occur. Further, in the process of forming the FTI structure 210A, the opening between the semiconductor regions 245A and 245B, which is usually formed by removing a dummy conductive structure between the semiconductor regions 245A and 245B, can cause electrical shortage between contacts over the semiconductor regions 245A and 245B. These drawbacks of the FTI structures 210 can result in performance degradation of the IC device 200.

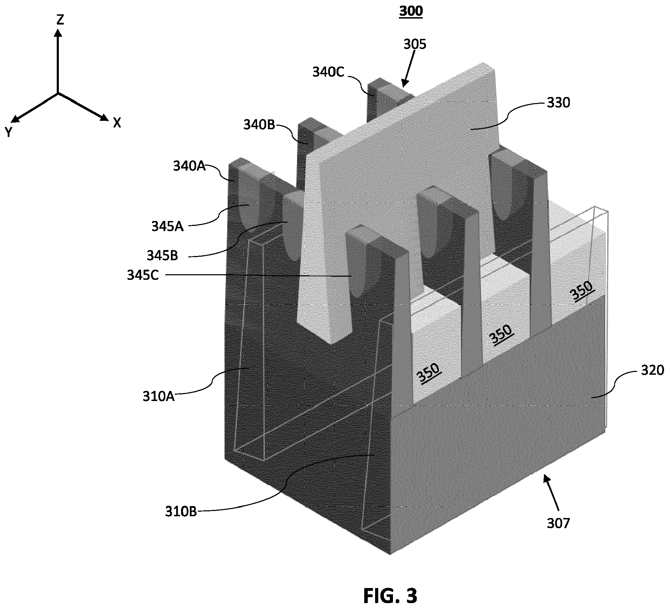

FIG. 3 illustrates an IC device comprising a backside FTI, according to some embodiments of the disclosure. FIG. 3 shows a perspective view of the IC device 300. The IC device 300 has a frontside 305 and a backside 307. The IC device 300 includes two FTI structures 310A and 310B (collectively referred to as "FTI structures 310" or "FTI structure 310"), a support structure 320, a conductive structure 330, semiconductor structures 340A-240C (collectively referred to as "semiconductor structures 340" or "semiconductor structure 340"), and insulative structures 350 (individually referred to as "insulative structure 350"). In other embodiments, the IC device 300 may include fewer, more, or different components.

The support structure 320 is below the semiconductor structures 340 and the insulative structures 350. In some embodiments, the support structure 360 may include a semiconductor material. Additionally or alternatively, the support structure 360 may include an insulator, such as an oxide. The support structure 360 may be an embodiment of the support structure 115 in FIG. 1.

The FTI structures 310 can separate adjacent transistors formed over the support structure 320. The FTI structures 210 include one or more dielectric materials. The FTI structures 310 may be examples of the FTI structure 150 in FIG. 1. The FTI structures 310 are backside FTI structures as they are formed from the backside 307 of the IC device 300. The backside 307 opposes the frontside 305 along the Z axis. The top surfaces of the semiconductor structures 340 are at the frontside 305, versus the bottom surface of the support structure is at the backside 307. The FTI structures 310 may be formed by forming openings from the frontside 305. As a result, the bottom surface of a FTI structure 310 is larger than the top surface of the FTI structure 310, i.e., the FTI structure 310 gradually narrows in the direction from the backside 307 to the frontside 305. The transistors include semiconductive regions that are various portions of the semiconductor structures 340.

A longitudinal axis of each FTI structure 310 is along the Y axis, which is in parallel with a longitudinal axis of the conductive structure 330. The conductive structure 330 includes one or more electrically conductive materials, such as metal. Even though FIG. 3 shows one conductive structure 330, the IC device 300 may include one or more other conductive structures. The insulative structures 350 are between the conductive structures 330 and the support structure 320. Each insulative structures 350 is between a portion of conductive structures 330 and the support structure 320 for insulating the conductive structures 330 from the support structure 320.

The semiconductor structures 340 have longitudinal axes along the X axis, which is perpendicular to the longitudinal axes of the FTI structures 310 and the conductive structure 330. In the embodiments of FIG. 3, the semiconductor structures 340 are fins. In other embodiments, the semiconductor structures 340 may have other structures, such as nanoribbon. As shown in FIG. 3, each semiconductor structure 340 crosses the conductive structure 330. Each semiconductor structure 340 may include a plurality of source regions, drain regions, and channel regions. For the purpose of illustration, each semiconductor structure 340 includes three semiconductor regions 345A-245C (collectively referred to as "semiconductor regions 345" or "semiconductor region 345") in FIG. 3.

Each semiconductor region 345 may be a source region or a drain region of a transistor. For instance, the semiconductor regions 345B and 345C may be the source region and drain region of a transistor. The channel region of the transistor may be the portion of the semiconductor structure 340 that is wrapped by the conductive structure 330 and is between the semiconductor regions 345B and 345C. The semiconductor region 345A is the source or drain region of another transistor that may function separately from the transistor including the semiconductor regions 345B and 345C. The FTI structure 310A is between the two transistors and can prevent current leakage between the two transistors. Similarly, the FTI structure 310B can prevent current leakage between the transistor including the semiconductor regions 345B and 345C and another transistor, which is not shown in FIG. 3.

The top surface of each semiconductor structure 340 is smaller than the bottom surface of the semiconductor structure 340, i.e., the semiconductor structures 340 gradually narrow in the direction from the backside 307 to the frontside 305. As described above, the FTI structures 310 also gradually narrow in the direction from the backside 307 to the frontside 305. With such shapes of the semiconductor structures 340 and FTI structures 310, FTI fangs (e.g., the FTI fang 225 shown in FIG. 2) can be avoided. As show in FIG. 3, an edge of the semiconductor structure 340A is aligned with an edge of the FTI structure 310B, and there is no FTI fang in the semiconductor structure 340A. EPI damages and shortage between contacts over the semiconductor regions 345A and 345B can also be prevented. Therefore, compared with the IC device 200 in FIG. 2, the IC device 300 in FIG. 3 can have better performance due to the implement of backside FTI.

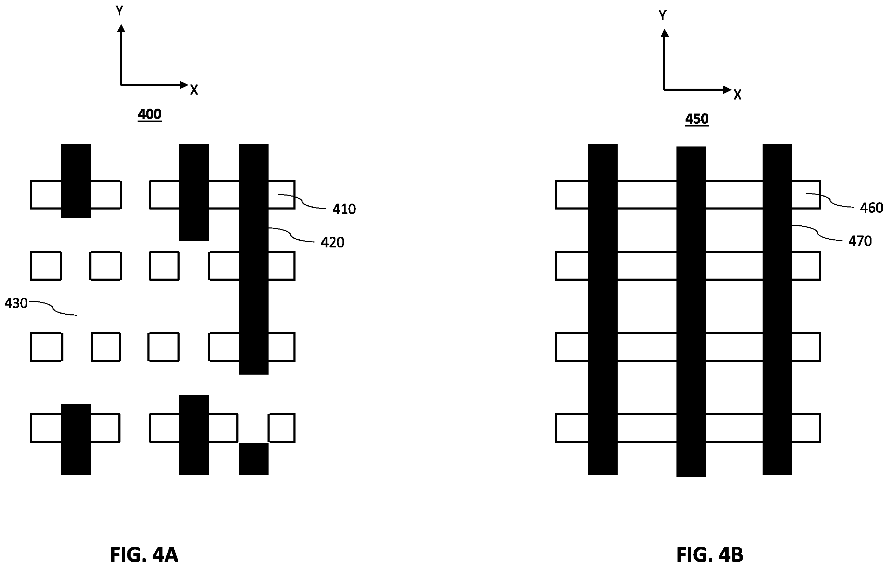

FIG. 4A is a top view of an IC device 400 with frontside FTI, according to some embodiments of the disclosure. An example of the IC device 400 may be the IC device 200 in FIG. 2. The top view of the IC device 400 shows semiconductor structures 410 (individually referred to as "semiconductor structure 410"), conductive structures 420 (individually referred to as "conductive structure 420"), and frontside FTI structures 430 (individually referred to as "frontside FTI structure 430"). The frontside FTI structures 430 are formed in openings that are formed in the conductive structures 420, respectively. As the openings are at the frontside of the IC device, the conductive structures 420 do not have uniform contour.

FIG. 4B is a top view of an IC device 450 with backside FTI, according to some embodiments of the disclosure. An example of the IC device 450 may be the IC device 300 in FIG. 3. The top view of the IC device 400 semiconductor structures 460 (individually referred to as "semiconductor structure 460") and conductive structures 470 (individually referred to as "conductive structure 470"). As FTI structures in the IC device 450 are formed from the backside, they are not visible in the top view shown in FIG. 4B. The conductive structures 470 have uniform contour. Compared with the conductive structures 420 in FIG. 4A, the conductive structures 470 in FIG. 4B have less variations between each other, which can make it easier to control downstream processes of fabricating the IC device 450.

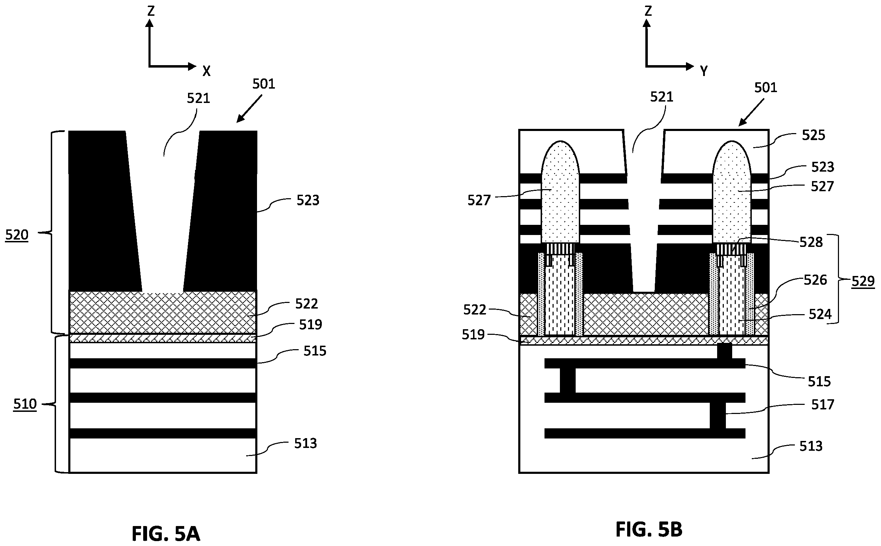

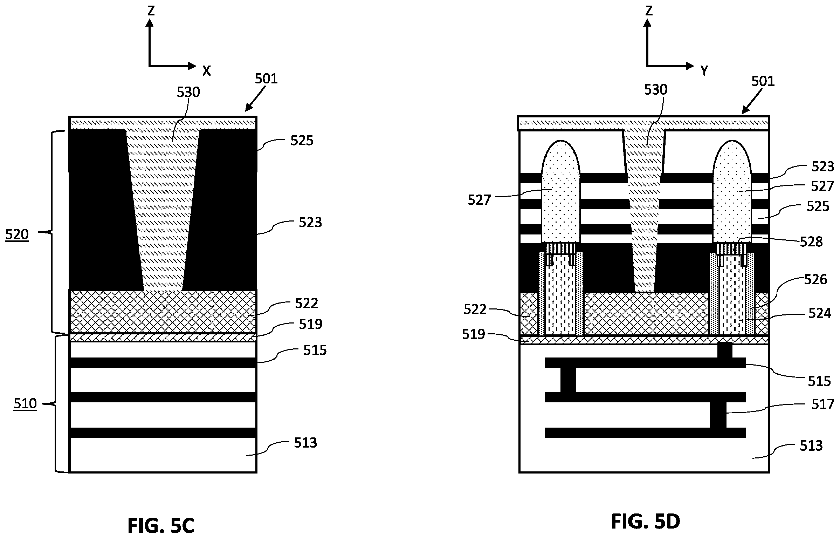

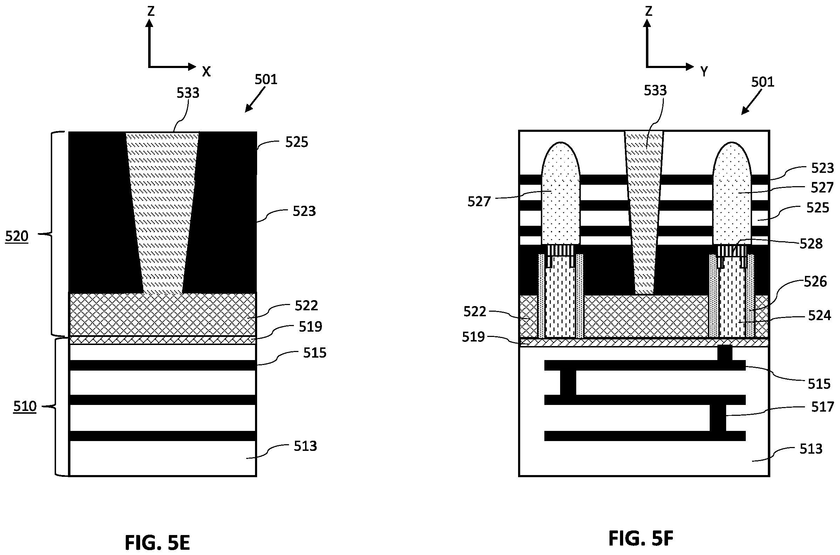

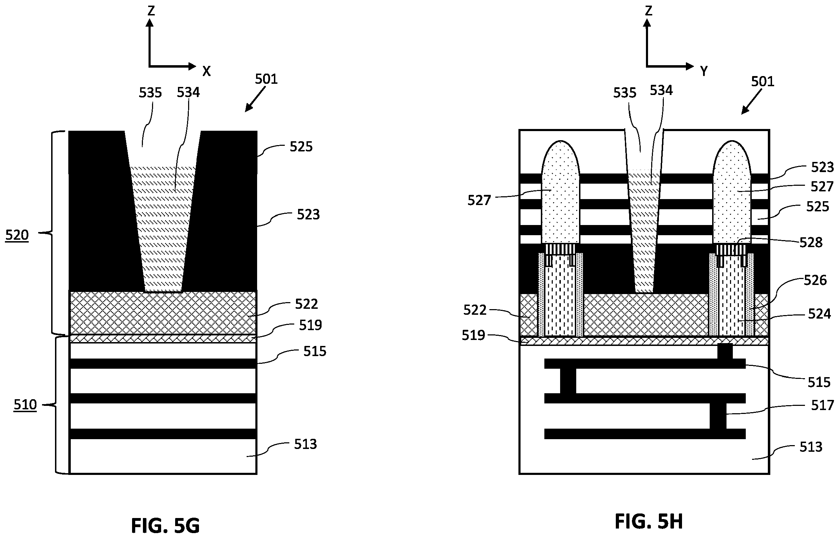

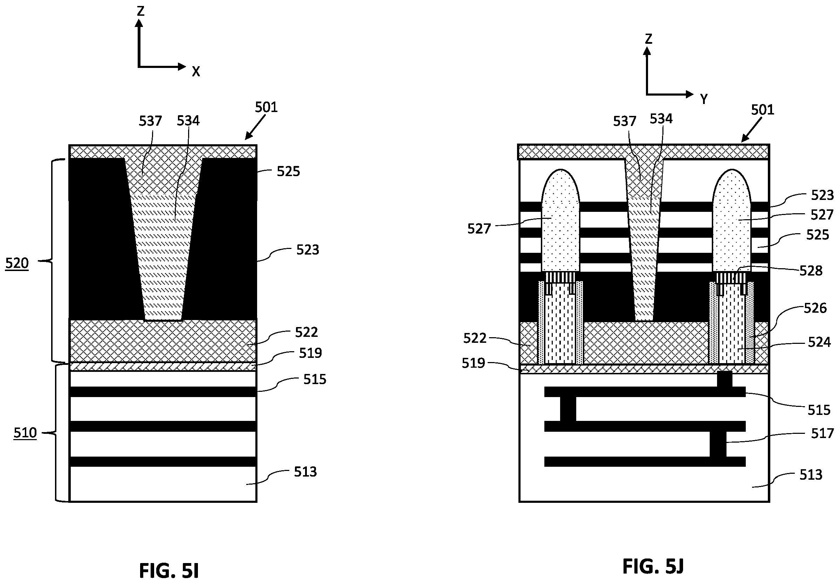

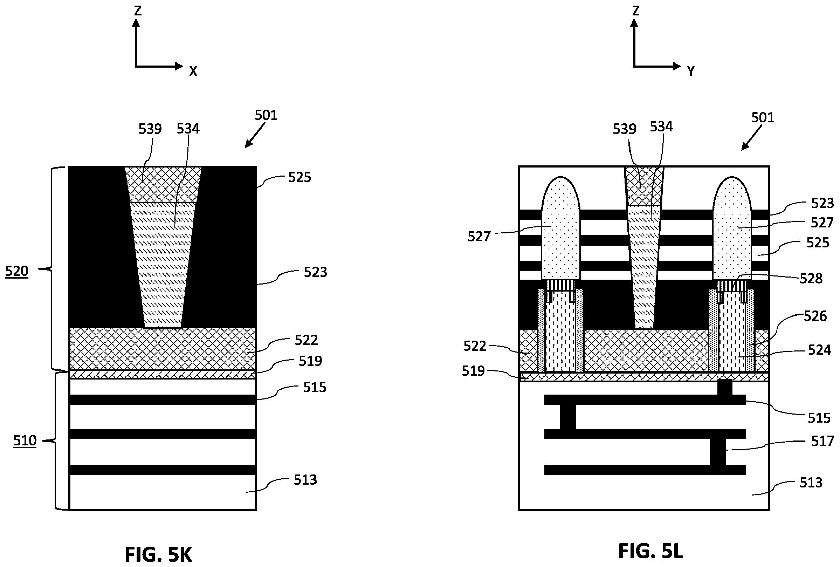

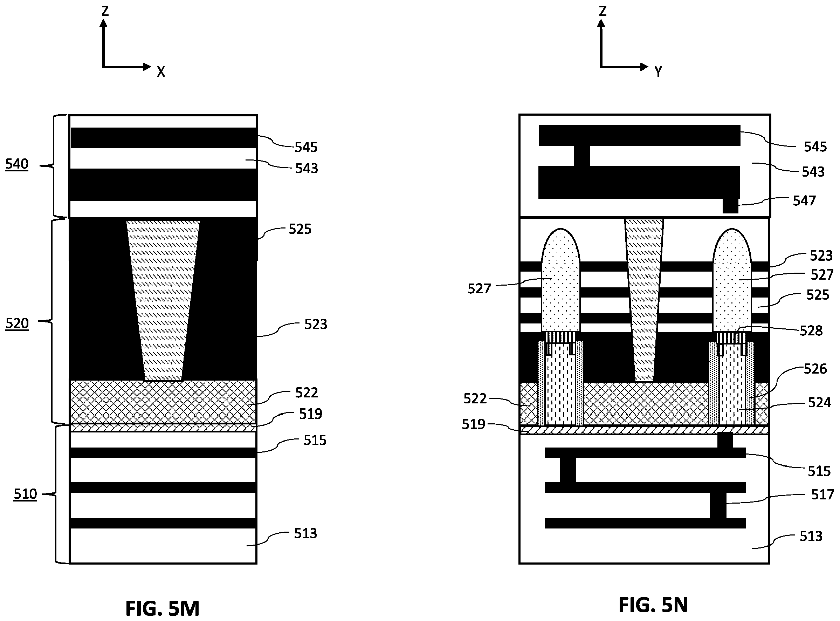

FIGS. 5A-5N illustrate a process of forming backside FTI, according to some embodiments of the disclosure. The process may be used to form the FTI structure 150 in FIG. 1 or the FTI structures 310 in FIG. 3. FIGS. 5A, 5C, 5E, 5G, 5I, 5K, and 5M shows cross-sectional views in the parallel-to-gate direction (PGD). FIGS. 5B, 5D, 5F, 5H, 5J, 5L, and 5N shows cross-sectional views in the orthogonal-to-gate direction (OGD).

FIGS. 5A and 5B shows an opening formed at the backside of an IC device. The IC device has a backside 501. The IC device includes a BEOL section 510 and a FEOL section 520. The BEOL section 510 includes an insulative structure 513, metal layers 515 (individually referred to as "metal layer 515"), vias 517 (individually referred to as "via 517"), and a contact layer 519. The BEOL section 510 may be an embodiment of the BEOL section 120 in FIG. 1. The FEOL section 520 includes conductive structures 523 (individually referred to as "conductive structure 523"), a support structure 525, semiconductor regions 527 (individually referred to as "semiconductor region 527"), semiconductor contacts 529 (individually referred to as "semiconductor contact 529"), and a dielectric layer 522. A semiconductor contact 529 includes a conductive structure 524, a spacer 526, and a contact structure 528. In other embodiments, the IC device may include fewer, more, or different components. The conductive structures 523 may be examples of the conductive structures 160 in FIG. 1 or the conductive structure 330 in FIG. 3. The support structure 525 may be examples of the support structure 115 in FIG. 1 or the support structure 320 in FIG. 3. The semiconductor regions 527 may be examples of the semiconductor regions 130 in FIG. 1 or the semiconductor regions 345 in FIG. 3. The dielectric layer 522 may be an embodiment of the dielectric layer 180 in FIG. 1.

As shown in FIGS. 5A and 5B, an opening 521 is formed through the conductive structures 523 and portions of the support structure 525. The opening 521 is formed from the backside 501 of the IC device for fabricating backside FTI. The conductive structures 523 may function as the gate electrodes of one or more transistors in the FEOL section 520. Portions of the support structure 525 under the conductive structures 523 may be channel regions of the one or more transistors. As shown in FIG. 5B, the channel regions are ribbon structures (e.g., nanoribbon). In other embodiments, the channel regions may be other types of structures. A semiconductor region 527 may be the source or drain region of the transistor. For the purpose of illustration, FIG. 5B shows two semiconductor regions 527. In other embodiments, the IC device may include more semiconductor regions 527. In some embodiments, one of the semiconductor regions 527 is the source region of a transistor, and the other one of the semiconductor regions 527 is the drain region of another transistor.

In FIGS. 5C and 5D, the opening 521 is filled with one or more dielectric materials, and a dielectric structure 530 is formed. The dielectric structure 530 can be formed by providing the one or more dielectric materials to the opening 521. In some embodiments, the dielectric structure 530 is formed through deposition. The deposition may be chemical vapor deposition (e.g., plasma enhanced chemical vapor deposition, atomic layer deposition, etc.), physical vapor deposition (e.g., thermal evaporation, etc.) and so on. A portion of the dielectric structure 530 is in the opening 521, and the rest of the dielectric structure 530 is outside the opening and is over the backside 501. The dielectric material can prevent current leakage between the two transistors that respectively include the semiconductor regions 527. For instance, charge diffusion between the two semiconductor regions 527 can be reduced or eliminated by the dielectric material.

In FIGS. 5E and 5F, a portion of the dielectric structure 530 is removed, e.g., by polishing. A dielectric structure 533 is formed. The dielectric structure 533 is between the semiconductor regions 527.

In FIGS. 5G and 5H, a portion of the dielectric structure 533 is removed, e.g., by etching. A new dielectric structure 534 and a recess 535 is formed. The recess 535 is over the dielectric structure 534.

In FIGS. 5G and 5H, a portion of the dielectric structure 533 is removed, e.g., by etching. A new dielectric structure 534 and a recess 535 is formed. The recess 535 is over the dielectric structure 534.

In FIGS. 5I and 5J, a dielectric structure 537 is formed. A portion of the dielectric structure 537 is in the recess 535, and another portion of the dielectric structure 537 is over the backside 501. The dielectric structure 537 may be formed by depositing one or more dielectric materials into the recess 535. The deposition may be chemical vapor deposition (e.g., plasma enhanced chemical vapor deposition, atomic layer deposition, etc.), physical vapor deposition (e.g., thermal evaporation, etc.) and so on. The dielectric structure 537 is over the dielectric structure 534. The dielectric structure 537 may include a different material from the dielectric structure 534. For instance, the dielectric structure 534 may include one or more low-k dielectric materials, such as an oxide or other low-k dielectric materials. Example oxide in the dielectric structure 534 may include silicon oxide (SiO), silicon oxycarbide (SiOC), silicon oxycarbonitride (SiOCN), and so on. The dielectric structure 537 may include a nitride or carbide, such as silicon nitride (SiN), silicon carbide (SiC), silicon carbonitride (SiCN), and so on.

In some embodiments, the dielectric structure 537 may have a higher etch selectivity than the dielectric structure 534. For instance, the dielectric structure 537 may function as a mask for etching another structure, i.e., the target structure of the etching process. The difference between the etch rate of the dielectric structure 537 and the etch rate of the target structure may be more significant than the difference between the etch rate of the dielectric structure 534 and the etch rate of the target structure. For instance, the dielectric structure 537 may be etched at a lower rate than the target structure, versus the dielectric structure 534 may be etched at a similar rate as the target structure.

In FIGS. 5K and 5L, a portion of the dielectric structure 537 is removed, e.g., by polishing. A dielectric structure 539 is formed. The dielectric structure 539 is between the semiconductor regions 527 and is over the dielectric structure 534. The dielectric structure 534 and the dielectric structure 539 constitutes a backside FTI structure of the IC device. The backside FTI structure can reduce or even eliminate charge diffusion between the semiconductor regions 527. The backside FTI structure may be an embodiment of the FTI structure 150 in FIG. 1 or the FTI structure 310 in FIG. 3. As shown in FIGS. 5K and 5L, the backside FTI structure has a larger surface at the backside 501 but the opposing surface (which is at the interface of a conductive structure 523 and the dielectric layer 522) is smaller. Even though not shown in FIGS. 5K and 5L, a semiconductor structure that includes the semiconductor regions 527 may have a similar shape, i.e., the semiconductor structure has a larger surface at the backside 501 and narrows down in the direction from the backside 501 towards the dielectric layer 522. Due to the similarity in the shapes of the backside FTI structure and the semiconductor structure, the drawbacks of frontside FTI (e.g., EPI damage, trench contact shortage, FTI fang, etc.), which can cause degradation in the performance of the IC device, can be avoided.

After the backside FTI structure is formed, further structures may be fabricated at the backside 501. In FIGS. 5M and 5N, a backside section 540 is formed. The backside section 540 is formed at the backside 501 of the IC device and contacts the larger surface of the backside FTI structure, i.e., the larger surface of the dielectric structure 539. The backside section 540 includes an insulative structure 543, metal layers 545 (individually referred to as "metal layer 545"), and vias 547 (individually referred to as "via 547"). The insulative structure 545 may include one or more electrical insulators. The vias 547 may be used to electrically couple the metal layers 545 with each other or with other components of the IC device, e.g., with a transistor or with a metal layer 515. The metal layers 545 and vias 547 may each include one or more electrically conductive materials, such as metal. The metal layers 545 may be referred to as backside metal layers, versus the metal layers 515 are referred to as frontside metal layers. A metal layer 545 may be thicker than a metal layer 515, e.g., have a larger dimension along the Z axis. A metal layer 515 or 545 may be used to provide electrical signals to the transistors in the IC device. In some embodiments, a metal layer 515 or 545 may function as a power plane or ground plane. Even though FIGS. 5M and 5N show two metal layers 545, the backside section 540 may include a different number of metal layers.

FIGS. 6A-6B are top views of a wafer 2000 and dies 2002 that may include backside FTI, according to some embodiments of the disclosure. In some embodiments, the dies 2002 may be included in an IC package, according to some embodiments of the disclosure. For example, any of the dies 2002 may serve as any of the dies 2256 in an IC package 2200 shown in FIG. 7. The wafer 2000 may be composed of semiconductor material and may include one or more dies 2002 having IC devices formed on a surface of the wafer 2000. Each of the dies 2002 may be a repeating unit of a semiconductor product that includes any suitable IC (e.g., ICs including backside FTI as described herein). After the fabrication of the semiconductor product is complete (e.g., after manufacture of backside FTI as described herein), the wafer 2000 may undergo a singulation process in which each of the dies 2002 is separated from one another to provide discrete "chips" of the semiconductor product. In particular, devices that include backside FTI as disclosed herein may take the form of the wafer 2000 (e.g., not singulated) or the form of the die 2002 (e.g., singulated). The die 2002 may include one or more diodes, one or more transistors as well as, optionally, supporting circuitry to route electrical signals to the III-N diodes with n-doped wells and capping layers and III-N transistors, as well as any other IC components. In some embodiments, the wafer 2000 or the die 2002 may implement an electrostatic discharge (ESD) protection device, a radio frequency front-end device, a memory device (e.g., a static random-access memory (SRAM) device), a logic device (e.g., an AND, OR, NAND, or NOR gate), or any other suitable circuit element. Multiple ones of these devices may be combined on a single die 2002.

FIG. 7 is a side, cross-sectional view of an example IC package 2200 that may include one or more IC devices having backside FTI, according to some embodiments of the disclosure. In some embodiments, the IC package 2200 may be a system-in-package (SiP).

As shown in FIG. 7, the IC package 2200 may include a package substrate 2252. The package substrate 2252 may be formed of a dielectric material (e.g., a ceramic, a glass, a combination of organic and inorganic materials, a buildup film, an epoxy film having filler particles therein, etc., and may have embedded portions having different materials), and may have conductive pathways extending through the dielectric material between the face 2272 and the face 2274, or between different locations on the face 2272, and/or between different locations on the face 2274.

The package substrate 2252 may include conductive contacts 2263 that are coupled to conductive pathways 2262 through the package substrate 2252, allowing circuitry within the dies 2256 and/or the interposer 2257 to electrically couple to various ones of the conductive contacts 2264 (or to other devices included in the package substrate 2252, not shown).

The IC package 2200 may include an interposer 2257 coupled to the package substrate 2252 via conductive contacts 2261 of the interposer 2257, first-level interconnects 2265, and the conductive contacts 2263 of the package substrate 2252. The first-level interconnects 2265 illustrated in FIG. 7 are solder bumps, but any suitable first-level interconnects 2265 may be used. In some embodiments, no interposer 2257 may be included in the IC package 2200; instead, the dies 2256 may be coupled directly to the conductive contacts 2263 at the face 2272 by first-level interconnects 2265.

The IC package 2200 may include one or more dies 2256 coupled to the interposer 2257 via conductive contacts 2254 of the dies 2256, first-level interconnects 2258, and conductive contacts 2260 of the interposer 2257. The conductive contacts 2260 may be coupled to conductive pathways (not shown) through the interposer 2257, allowing circuitry within the dies 2256 to electrically couple to various ones of the conductive contacts 2261 (or to other devices included in the interposer 2257, not shown). The first-level interconnects 2258 illustrated in FIG. 7 are solder bumps, but any suitable first-level interconnects 2258 may be used. As used herein, a "conductive contact" may refer to a portion of electrically conductive material (e.g., metal) serving as an interface between different components; conductive contacts may be recessed in, flush with, or extending away from a surface of a component, and may take any suitable form (e.g., a conductive pad or socket).

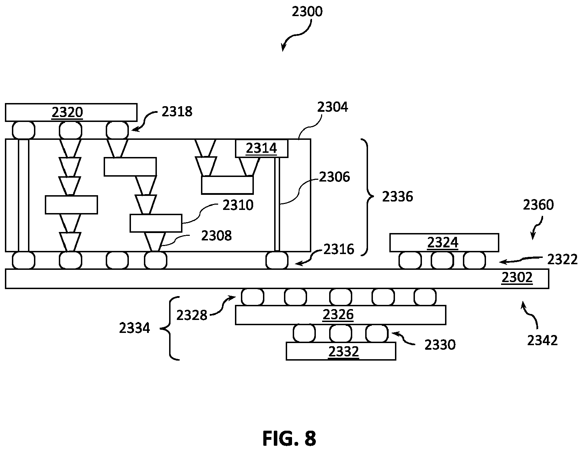

In some embodiments, an underfill material 2266 may be disposed between the package substrate 2252 and the interposer 2257 around the first-level interconnects 2265, and a mold compound 2268 may be disposed around the dies 2256 and the interposer 2257 and in contact with the package substrate 2252. In some embodiments, the underfill material 2266 may be the same as the mold compound 2268. Example materials that may be used for the underfill material 2266 and the mold compound 2268 are epoxy mold materials, as suitable. Second-level interconnects 2270 may be coupled to the conductive contacts 2264. The second-level interconnects 2270 illustrated in FIG. 7 are solder balls (e.g., for a ball grid array arrangement), but any suitable second-level interconnects 2270 may be used (e.g., pins in a pin grid array arrangement or lands in a land grid array arrangement). The second-level interconnects 2270 may be used to couple the IC package 2200 to another component, such as a circuit board (e.g., a motherboard), an interposer, or another IC package, as known in the art and as discussed below with reference to FIG. 8.

The dies 2256 may take the form of any of the embodiments of the die 2002 discussed herein and may include any of the embodiments of an IC device having backside FTI. In embodiments in which the IC package 2200 includes multiple dies 2256, the IC package 2200 may be referred to as a multi-chip package. Importantly, even in such embodiments of an MCP implementation of the IC package 2200, backside FTI may be provided in a single chip, in accordance with any of the embodiments described herein. The dies 2256 may include circuitry to perform any desired functionality. For example, one or more of the dies 2256 may be ESD protection dies, including backside FTI as described herein, one or more of the dies 2256 may be logic dies (e.g., silicon-based dies), one or more of the dies 2256 may be memory dies (e.g., high bandwidth memory), etc. In some embodiments, any of the dies 2256 may include backside FTI, e.g., as discussed above; in some embodiments, at least some of the dies 2256 may not include any III-N diodes with n-doped wells and capping layers.

The IC package 2200 illustrated in FIG. 7 may be a flip chip package, although other package architectures may be used. For example, the IC package 2200 may be a ball grid array (BGA) package, such as an embedded wafer-level ball grid array (eWLB) package. In another example, the IC package 2200 may be a wafer-level chip scale package (WLCSP) or a panel fan-out (FO) package. Although two dies 2256 are illustrated in the IC package 2200 of FIG. 7, an IC package 2200 may include any desired number of the dies 2256. An IC package 2200 may include additional passive components, such as surface-mount resistors, capacitors, and inductors disposed on the first face 2272 or the second face 2274 of the package substrate 2252, or on either face of the interposer 2257. More generally, an IC package 2200 may include any other active or passive components known in the art.

FIG. 8 is a cross-sectional side view of an IC device assembly 2300 that may include components having one or more IC devices implementing backside FTI, according to some embodiments of the disclosure. The IC device assembly 2300 includes a number of components disposed on a circuit board 2302 (which may be, e.g., a motherboard). The IC device assembly 2300 includes components disposed on a first face 2340 of the circuit board 2302 and an opposing second face 2342 of the circuit board 2302; generally, components may be disposed on one or both faces 2340 and 2342. In particular, any suitable ones of the components of the IC device assembly 2300 may include any of the IC devices implementing backside FTI in accordance with any of the embodiments disclosed herein; e.g., any of the IC packages discussed below with reference to the IC device assembly 2300 may take the form of any of the embodiments of the IC package 2200 discussed above with reference to FIG. 7 (e.g., may include backside FTI in/on a die 2256).

In some embodiments, the circuit board 2302 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 2302. In other embodiments, the circuit board 2302 may be a non-PCB substrate.

The IC device assembly 2300 illustrated in FIG. 8 includes a package-on-interposer structure 2336 coupled to the first face 2340 of the circuit board 2302 by coupling components 2316. The coupling components 2316 may electrically and mechanically couple the package-on-interposer structure 2336 to the circuit board 2302, and may include solder balls (e.g., as shown in FIG. 8), male and female portions of a socket, an adhesive, an underfill material, and/or any other suitable electrical and/or mechanical coupling structure.

The package-on-interposer structure 2336 may include an IC package 2320 coupled to an interposer 2304 by coupling components 2318. The coupling components 2318 may take any suitable form for the application, such as the forms discussed above with reference to the coupling components 2316. The IC package 2320 may be or include, for example, a die (the die 2002 of FIG. 6B), an IC device (e.g., the IC device of FIGS. 1-2), or any other suitable component. In particular, the IC package 2320 may include backside FTI as described herein. Although a single IC package 2320 is shown in FIG. 8, multiple IC packages may be coupled to the interposer 2304; indeed, additional interposers may be coupled to the interposer 2304. The interposer 2304 may provide an intervening substrate used to bridge the circuit board 2302 and the IC package 2320. Generally, the interposer 2304 may spread a connection to a wider pitch or reroute a connection to a different connection. For example, the interposer 2304 may couple the IC package 2320 (e.g., a die) to a BGA of the coupling components 2316 for coupling to the circuit board 2302. In the embodiment illustrated in FIG. 8, the IC package 2320 and the circuit board 2302 are attached to opposing sides of the interposer 2304; in other embodiments, the IC package 2320 and the circuit board 2302 may be attached to a same side of the interposer 2304. In some embodiments, three or more components may be interconnected by way of the interposer 2304.

The interposer 2304 may be formed of an epoxy resin, a fiberglass-reinforced epoxy resin, a ceramic material, or a polymer material such as polyimide. In some implementations, the interposer 2304 may be formed of alternate rigid or flexible materials that may include the same materials described above for use in a semiconductor substrate, such as silicon, germanium, and other group III-V and group IV materials. The interposer 2304 may include metal interconnects 2308 and vias 2310, including but not limited to TSVs 2306. The interposer 2304 may further include embedded devices 2314, including both passive and active devices. Such devices may include, but are not limited to, capacitors, decoupling capacitors, resistors, inductors, fuses, diodes, transformers, sensors, ESD protection devices, and memory devices. More complex devices such as further RF (radio frequency) devices, power amplifiers, power management devices, antennas, arrays, sensors, and microelectromechanical systems (MEMS) devices may also be formed on the interposer 2304. In some embodiments, the IC devices implementing backside FTI as described herein may also be implemented in/on the interposer 2304. The package-on-interposer structure 2336 may take the form of any of the package-on-interposer structures known in the art.

The IC device assembly 2300 may include an IC package 2324 coupled to the first face 2340 of the circuit board 2302 by coupling components 2322. The coupling components 2322 may take the form of any of the embodiments discussed above with reference to the coupling components 2316, and the IC package 2324 may take the form of any of the embodiments discussed above with reference to the IC package 2320.

The IC device assembly 2300 illustrated in FIG. 8 includes a package-on-package structure 2334 coupled to the second face 2342 of the circuit board 2302 by coupling components 2328. The package-on-package structure 2334 may include an IC package 2326 and an IC package 2332 coupled together by coupling components 2330 such that the IC package 2326 is disposed between the circuit board 2302 and the IC package 2332. The coupling components 2328 and 2330 may take the form of any of the embodiments of the coupling components 2316 discussed above, and the IC packages 2326 and 2332 may take the form of any of the embodiments of the IC package 2320 discussed above. The package-on-package structure 2334 may be configured in accordance with any of the package-on-package structures known in the art.

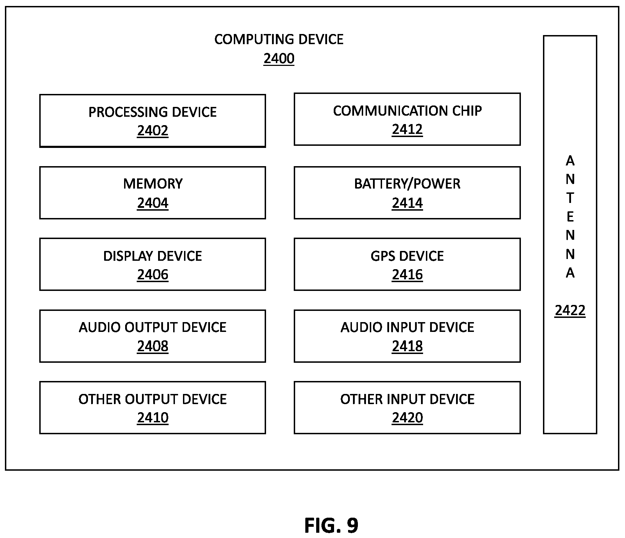

FIG. 9 is a block diagram of an example computing device 2400 that may include one or more components with one or more IC devices having backside FTI, according to some embodiments of the disclosure. For example, any suitable ones of the components of the computing device 2400 may include a die (e.g., the die 2002 of FIG. 6B) including backside FTI, according to some embodiments of the disclosure. Any of the components of the computing device 2400 may include backside FTI (e.g., any embodiment of backside FTI described above in conjunction with FIGS. 1, 3A, 3B, and 5A-5N) and/or an IC package (e.g., the IC package 2200 of FIG. 7). Any of the components of the computing device 2400 may include an IC device assembly (e.g., the IC device assembly 2300 of FIG. 8).

A number of components are illustrated in FIG. 9 as included in the computing device 2400, but any one or more of these components may be omitted or duplicated, as suitable for the application. In some embodiments, some or all of the components included in the computing device 2400 may be attached to one or more motherboards. In some embodiments, some or all of these components are fabricated onto a single SoC (system-on-chip) die.

Additionally, in various embodiments, the computing device 2400 may not include one or more of the components illustrated in FIG. 9, but the computing device 2400 may include interface circuitry for coupling to the one or more components. For example, the computing device 2400 may not include a display device 2406, but may include display device interface circuitry (e.g., a connector and driver circuitry) to which a display device 2406 may be coupled. In another set of examples, the computing device 2400 may not include an audio input device 2418 or an audio output device 2408, but may include audio input or output device interface circuitry (e.g., connectors and supporting circuitry) to which an audio input device 2418 or audio output device 2408 may be coupled.

The computing device 2400 may include a processing device 2402 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 2402 may include one or more digital signal processors (DSPs), application-specific ICs (ASICs), central processing units (CPUs), graphics processing units (GPUs), cryptoprocessors (specialized processors that execute cryptographic algorithms within hardware), server processors, or any other suitable processing devices. The computing device 2400 may include a memory 2404, which may itself include one or more memory devices such as volatile memory (e.g., DRAM), nonvolatile memory (e.g., read-only memory (ROM)), flash memory, solid-state memory, and/or a hard drive. In some embodiments, the memory 2404 may include memory that shares a die with the processing device 2402. This memory may be used as cache memory and may include, e.g., eDRAM, and/or spin transfer torque magnetic random-access memory (STT-MRAM).

In some embodiments, the computing device 2400 may include a communication chip 2412 (e.g., one or more communication chips). For example, the communication chip 2412 may be configured for managing wireless communications for the transfer of data to and from the computing device 2400. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 2412 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 2412 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 2412 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 2412 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 2412 may operate in accordance with other wireless protocols in other embodiments. The computing device 2400 may include an antenna 2422 to facilitate wireless communications and/or to receive other wireless communications (such as AM or FM radio transmissions).

In some embodiments, the communication chip 2412 may manage wired communications, such as electrical, optical, or any other suitable communication protocols (e.g., the Ethernet). As noted above, the communication chip 2412 may include multiple communication chips. For instance, a first communication chip 2412 may be dedicated to shorter-range wireless communications such as Wi-Fi or Bluetooth, and a second communication chip 2412 may be dedicated to longer-range wireless communications such as global positioning system (GPS), EDGE, GPRS, CDMA, WiMAX, LTE, EV-DO, or others. In some embodiments, a first communication chip 2412 may be dedicated to wireless communications, and a second communication chip 2412 may be dedicated to wired communications.

In various embodiments, IC devices having backside FTI as described herein may be particularly advantageous for use as part of ESD circuits protecting power amplifiers, low-noise amplifiers, filters (including arrays of filters and filter banks), switches, or other active components. In some embodiments, IC devices having backside FTI as described herein may be used in PMICs, e.g., as a rectifying diode for large currents. In some embodiments, IC devices having backside FTI as described herein may be used in audio devices and/or in various input/output devices.

The computing device 2400 may include battery/power circuitry 2414. The battery/power circuitry 2414 may include one or more energy storage devices (e.g., batteries or capacitors) and/or circuitry for coupling components of the computing device 2400 to an energy source separate from the computing device 2400 (e.g., AC line power).

The computing device 2400 may include a display device 2406 (or corresponding interface circuitry, as discussed above). The display device 2406 may include any visual indicators, such as a heads-up display, a computer monitor, a projector, a touchscreen display, a liquid crystal display (LCD), a light-emitting diode display, or a flat panel display, for example.

The computing device 2400 may include an audio output device 2408 (or corresponding interface circuitry, as discussed above). The audio output device 2408 may include any device that generates an audible indicator, such as speakers, headsets, or earbuds, for example.

The computing device 2400 may include an audio input device 2418 (or corresponding interface circuitry, as discussed above). The audio input device 2418 may include any device that generates a signal representative of a sound, such as microphones, microphone arrays, or digital instruments (e.g., instruments having a musical instrument digital interface (MIDI) output).

The computing device 2400 may include a GPS device 2416 (or corresponding interface circuitry, as discussed above). The GPS device 2416 may be in communication with a satellite-based system and may receive a location of the computing device 2400, as known in the art.

The computing device 2400 may include another output device 2410 (or corresponding interface circuitry, as discussed above). Examples of the other output device 2410 may include an audio codec, a video codec, a printer, a wired or wireless transmitter for providing information to other devices, or an additional storage device.

The computing device 2400 may include another input device 2420 (or corresponding interface circuitry, as discussed above). Examples of the other input device 2420 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The computing device 2400 may have any desired form factor, such as a handheld or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, the computing device 2400 may be any other electronic device that processes data.

The following paragraphs provide various examples of the embodiments disclosed herein.

Example 1 provides an IC device, including a first transistor including a source region and a source contact over the source region in a first direction; a second transistor including a drain region and a drain contact over the drain region in the first direction; and a dielectric structure between the source region of the first transistor and the drain region of the second transistor in a second direction that is substantially perpendicular to the first direction, the dielectric structure including a first surface and a second surface, where the first surface is over the second surface in the first direction, the first surface is closer to the source contact or the drain contact than the second surface, and the first surface has a smaller area than the second surface in a plane that is substantially perpendicular to the first direction.

Example 2 provides the IC device according to example 1, where the dielectric structure includes a first dielectric material at the first surface; and a second dielectric material at the second surface, where the second dielectric material is different from the first dielectric material.

Example 3 provides the IC device according to example 2, where the second dielectric material includes nitrogen or carbon.

Example 4 provides the IC device according to any of the preceding examples, where the source region of the first transistor or the drain region of the second transistor is at least part of a semiconductor structure, the semiconductor structure includes a third surface and a fourth surface, the third surface is over the fourth surface in the first direction, the third surface is closer to the source contact or the drain contact than the fourth surface, and the third surface has a larger area than the third surface in the plane that is substantially perpendicular to the first direction.

Example 5 provides the IC device according to example 4, where the semiconductor structure includes a fin or nanoribbon.

Example 6 provides the IC device according to any of the preceding examples, where at least part of the dielectric structure is surrounded by an electrically conductive material.

Example 7 provides the IC device according to any of the preceding examples, where the source contact or drain contact is electrically coupled to an electrically conductive layer, and the electrically conductive layer is closer to the first surface of the dielectric structure than the second surface of the dielectric structure.

Example 8 provides an IC device, including a substrate including a first surface and a second surface, the second surface opposing the first surface; a first semiconductor structure over the substrate, where the first semiconductor structure is closer to the first surface than the second surface; a second semiconductor structure over the substrate, where the second semiconductor structure is closer to the first surface than the second surface; and a dielectric structure between the first semiconductor structure and the second semiconductor structure, where at least part of the dielectric structure is in the substrate, and a surface of the dielectric structure is closer to the second surface than the first surface.

Example 9 provides the IC device according to example 8, where at least part of the first semiconductor structure is in a transistor, and at least part of the second semiconductor structure is in another transistor.

Example 10 provides the IC device according to example 9, where the dielectric structure includes nitrogen or carbon at the surface.

Example 11 provides the IC device according to any one of examples 8-10, where a first portion of the semiconductor structure is a source region or drain region of a first transistor, and a second portion of the semiconductor structure is a source region or drain region of a second transistor.

Example 12 provides the IC device according to example 11, where the dielectric structure is between the first portion and the second portion in the first direction.

Example 13 provides the IC device according any one of examples 8-12, where at least part of the dielectric structure is surrounded by an electrically conductive material.

Example 14 provides the IC device according to any one of examples 8-13, where the semiconductor structure is electrically coupled to an electrically conductive layer, and the electrically conductive layer is closer to the first surface of the substrate than the second surface of the substrate.

Example 15 provides a method for forming an IC device, including forming an opening in a structure between a first semiconductor region and a second semiconductor region; forming a dielectric structure by providing a first dielectric material into the opening, where a portion of the dielectric structure is surrounded by the structure; forming a first dielectric structure and a recess by removing a portion of the dielectric structure; and forming a second dielectric structure in the recess by providing a second dielectric material into the recess, where the second dielectric material is different from the first dielectric material, and a surface of the second dielectric structure is larger than a surface of the first dielectric structure.

Example 16 provides the method according to example 15, where the structure includes an electrically conductive material.

Example 17 provides the method according to example 15 or 16, where the first semiconductor region is in a first transistor, and the second semiconductor region is in a second transistor.

Example 18 provides the method according to any one of examples 15-17, where the first dielectric structure is between an electrically conductive layer than the second dielectric structure.

Example 19 provides the method according to example 18, further including after forming the second dielectric structure, forming an additional electrically conductive layer, where the second dielectric structure is between the first dielectric structurer and the additional electrically conductive layer.

Example 20 provides the method according to any one of examples 15-19, where the first semiconductor region or the second semiconductor region is a portion of a semiconductor structure, the semiconductor structure includes a first surface and a second surface, the second surface is closer to the second dielectric structure than the first surface, and the second surface is larger than the first surface.

Example 21 provides an IC package, including the IC device according to any one of examples 1-14; and a further IC component, coupled to the device.

Example 22 provides the IC package according to example 21, where the further IC component includes one of a package substrate, an interposer, or a further IC die.

Example 23 provides the IC package according to example 21 or 22, where the IC device according to any one of examples 1-14 may include, or be a part of, at least one of a memory device, a computing device, a wearable device, a handheld electronic device, and a wireless communications device.

Example 24 provides an electronic device, including a carrier substrate; and one or more of the IC device according to any one of examples 1-14 and the IC package according to any one of examples 21-23, coupled to the carrier substrate.

Example 25 provides the electronic device according to example 24, where the carrier substrate is a motherboard.

Example 26 provides the electronic device according to example 24, where the carrier substrate is a PCB.

Example 27 provides the electronic device according to any one of examples 24-26, where the electronic device is a wearable electronic device or handheld electronic device.

Example 28 provides the electronic device according to any one of examples 24-27, where the electronic device further includes one or more communication chips and an antenna.

Example 29 provides the electronic device according to any one of examples 24-28, where the electronic device is an RF transceiver.

Example 30 provides the electronic device according to any one of examples 24-28, where the electronic device is one of a switch, a power amplifier, a low-noise amplifier, a filter, a filter bank, a duplexer, an upconverter, or a downconverter of an RF communications device, e.g., of an RF transceiver.

Example 31 provides the electronic device according to any one of examples 24-30, where the electronic device is a computing device.

Example 32 provides the electronic device according to any one of examples 24-31, where the electronic device is included in a base station of a wireless communication system.

Example 33 provides the electronic device according to any one of examples 24-31, where the electronic device is included in a user equipment device of a wireless communication system.

Example 34 provides the method according to any one of examples 15-20, further including processes for forming the IC device according to any one of claims 1-14.

Example 35 provides the method according to any one of examples 15-20, further including processes for forming the IC package according to any one of the claims 21-23.

Example 36 provides the method according to any one of examples 15-20, further including processes for forming the electronic device according to any one of the claims 24-33.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. An integrated circuit (IC) device, comprising:
a first transistor comprising a source region and a source contact over the source region in a first direction;
a second transistor comprising a drain region and a drain contact over the drain region in the first direction; and
a dielectric structure between the source region of the first transistor and the drain region of the second transistor in a second direction that is substantially perpendicular to the first direction, the dielectric structure comprising a first surface and a second surface, wherein:
the first surface is over the second surface in the first direction,
the first surface is closer to the source contact or the drain contact than the second surface, and
the first surface has a smaller area than the second surface in a plane that is substantially perpendicular to the first direction.

2. The IC device according to claim 1, wherein the dielectric structure comprises:
a first structure comprising a first dielectric material; and
a second structure comprising a second dielectric material that is different from the first dielectric material,
wherein the first surface is a surface of the first structure, and the second surface is a surface of the second structure.

3. The IC device according to claim 2, wherein the second dielectric material comprises nitrogen or carbon.

4. The IC device according to any one of claims 1-3, wherein:
the source region of the first transistor or the drain region of the second transistor is at least part of a semiconductor structure,
the semiconductor structure comprises a third surface and a fourth surface,
the third surface is over the fourth surface in the first direction,
the third surface is closer to the source contact or the drain contact than the fourth surface, and
the third surface has a larger area than the third surface in the plane that is substantially perpendicular to the first direction.

5. The IC device according to any one of claims 1-4, wherein at least part of the dielectric structure is surrounded by an electrically conductive material.

6. The IC device according to any one of claims 1-5, wherein the source contact or drain contact is electrically coupled to an electrically conductive layer, and the electrically conductive layer is closer to the first surface of the dielectric structure than the second surface of the dielectric structure.

7. An integrated circuit (IC) device, comprising:
a substrate comprising a first surface and a second surface, the second surface opposing the first surface;
a semiconductor structure over the substrate, wherein the semiconductor structure is closer to the first surface than the second surface, and a longitudinal axis of the semiconductor structure is along a first direction; and
a dielectric structure at least partially in the substrate, wherein:
a longitudinal axis of the dielectric structure is along a second direction that is substantially perpendicular to the first direction, and
a surface of the dielectric structure is closer to the second surface than the first surface.

8. The IC device according to claim 7, wherein:
the dielectric structure comprising an additional surface opposing the surface,
the second surface is closer to the surface than the additional surface, and
the surface is larger than the additional surface.

9. The IC device according to claim 7 or 8, wherein a first portion of the semiconductor structure is a source region or drain region of a first transistor, a second portion of the semiconductor structure is a source region or drain region of a second transistor, and the dielectric structure is between the first portion and the second portion in the first direction.

10. The IC device according to any one of claims 7-9, wherein at least part of the dielectric structure is surrounded by an electrically conductive material.

11. The IC device according to any one of claims 7-10, wherein the semiconductor structure is electrically coupled to an electrically conductive layer, and the electrically conductive layer is closer to the first surface of the substrate than the second surface of the substrate.

12. A method for forming an integrated circuit (IC) device, comprising:
forming an opening in a structure between a first semiconductor region and a second semiconductor region;
forming a dielectric structure by providing a first dielectric material into the opening, wherein a portion of the dielectric structure is surrounded by the structure;
forming a first dielectric structure and a recess by removing a portion of the dielectric structure; and
forming a second dielectric structure in the recess by providing a second dielectric material into the recess, wherein the second dielectric material is different from the first dielectric material, and a surface of the second dielectric structure is larger than a surface of the first dielectric structure.

13. The method according to claim 12, wherein:
the structure comprises an electrically conductive material; or
the first semiconductor region is in a first transistor, and the second semiconductor region is in a second transistor.

14. The method according to claim 12 or 13, wherein the first dielectric structure is between an electrically conductive layer than the second dielectric structure, and the method further comprises:
after forming the second dielectric structure, forming an additional electrically conductive layer,
wherein the second dielectric structure is between the first dielectric structurer and the additional electrically conductive layer.

15. The method according to any one of claims 12-14, wherein:
the first semiconductor region or the second semiconductor region is a portion of a semiconductor structure,
the semiconductor structure comprises a first surface and a second surface,
the second surface is closer to the second dielectric structure than the first surface, and
the second surface is larger than the first surface.
